# FASCICULE DE BREVET EUROPEEN

(11) **EP 2 247 956 B1**
(45) Date de publication et mention de la délivrance du brevet: **20.06.2012**
(21) Numéro de dépôt: 09718762.9
(22) Date de dépôt: 25.02.2009
(51) Int. Cl.: G01R 33/02, G01R 33/04, G01R 33/05, G01C 17/28, G01C 17/30, G01R 33/00

(54) **PROCEDE DE FABRICATION D'UN CAPTEUR DE CHAMP MAGNETIQUE ET CAPTEUR DE CHAMP MAGNETIQUE OBTENU**
VERFAHREN ZUR HERSTELLUNG EINES MAGNETFELDSENSORS UND IN DIESEM VERFAHREN HERGESTELLTER MAGNETFELDSENSOR
METHOD FOR MAKING A MAGNETIC FIELD SENSOR AND MAGNETIC FIELD SENSOR THUS OBTAINED

(30) Priorité: 26.02.2008 FR 0851207
(43) Date de publication de la demande: 10.11.2010
(73) Titulaire: University Claude Bernard Lyon I, 69622 Villeurbanne Cedex (FR); Centre National de la Recherche Scientifique, 75794 Paris Cedex 16 (FR); ArcelorMittal - Stainless & Nickel Alloys, 93200 Saint Denis (FR)
(72) Inventeur: MOREL, Laurent, F-69100 Villeurbanne (FR); REYAL, Jean-Pierre, F-95610 Eragny (FR)
(74) Mandataire: Thibault, Jean-Marc
(86) Numéro de dépôt international: PCT/FR2009/050304
(87) Numéro de publication internationale: WO 2009/112764

(56) Documents cités:
- EP-A- 0 098 768
- EP-A- 1 387 179
- EP-A- 1 852 707
- WO-A-90/04150
- FR-A- 2 547 927
- FR-A- 2 740 556
- FR-A- 2 788 455
- FR-A- 2 817 622
- FR-A- 2 856 552
- FR-A- 2 860 594
- GB-A- 2 386 198

## Description

La présente invention concerne le domaine technique des capteurs de mesure d'un champ magnétique ou magnétomètres.

Lʹobjet de lʹinvention concerne plus particulièrement les magnétomètres de type flux gate ou magnéto-inductif.

Dans l'état de la technique, il est connu de nombreuses formes de réalisation de magnétomètres. De manière générale, un magnétomètre comporte une ou plusieurs sondes magnétiques comportant chacune un noyau magnétique associé à un bobinage. Ces noyaux magnétiques sont en général de faible épaisseur pouvant atteindre 25 µm. Selon un exemple de réalisation, le noyau magnétique est constitué de feuilles minces d'alliage ferromagnétique à haute perméabilité insérées dans deux demi-coquilles en alumine. Ces feuilles minces sont calées à l'aide de deux fils de cuivre. Après traitement de l'ensemble à haute température pour restaurer les propriétés magnétiques, ce mandrin d'alumine est utilisé pour l'enroulement d'un bobinage de cuivre de manière à obtenir une sonde avec un axe privilégié de mesure. Un magnétomètre comporte ainsi une sonde ou une série de sondes arrangées orthogonalement dans le cas d'une détermination vectorielle des champs magnétiques. Chaque sonde est couplée à un circuit de mesure et de commande de tout type connu en soi. Par exemple, le document WO 90/04150 décrit une application d'un magnétomètre pour mesurer les trois composantes du champ magnétique terrestre.

La fabrication de tels magnétomètres présente un certain nombre d'inconvénients liés notamment aux diverses opérations pour fabriquer les noyaux ainsi quʹà l'opération de traitement thermique des noyaux. Il est à noter que si l'utilisation d'un autre type d'alliage pour le noyau tel qu'un alliage amorphe permet de s'affranchir de l'opération de traitement thermique, ce type d'alliage est instable. Par ailleurs, l'assemblage de ces sondes afin de constituer un magnétomètre multiaxial s'avère relativement complexe à mener à bien.

Il est à noter quʹil est connu par la demande de brevet GB 2 386 198 de réaliser un détecteur de champ magnétique en assurant notamment l'assemblage de couches magnétiques minces découpées dans un même substrat de base.

La présente invention vise à remédier aux inconvénients de l'état de la technique en proposant une nouvelle méthode de fabrication d'un capteur de champ magnétique, conçue pour permettre une fabrication industrielle relativement simple et peu onéreuse tout en permettant un assemblage fiable et sûre des sondes entre elles.

Pour atteindre un tel objectif, le procédé de fabrication d'un capteur de champ magnétique comporte une série de n sondes, avec n > = 3, composées chacune d'un noyau d'alliages magnétiques associé à un bobinage.

Selon lʹinvention, le procédé comporte les étapes suivantes :
- assurer le dépôt des noyaux d'alliages magnétiques sur une plaque support amagnétique, sur au moins tout ou partie d'une surface correspondant à une série de n bandes s'étendant selon des axes concourants en un point d'intersection et reliées ensemble par une zone dʹintersection,
- avant ou après ce dépôt, découper dans ladite plaque support, les n bandes en les laissant reliées à la plaque support par au moins une attache,
- assembler chaque bande avec un bobinage,
- plier au moins une bande selon une ligne de pliage perpendiculaire à son axe.

Selon une variante avantageuse de mise en oeuvre, le procédé consiste à supprimer le ou les attaches pour détacher le capteur de la plaque support.

Selon une variante de réalisation de lʹinvention, le procédé consiste :
- à prédécouper le noyau d'alliages magnétiques en suivant le contour des bandes et en laissant subsister au moins une attache,
- à supprimer éventuellement le noyau d'alliages magnétiques de la zone d'intersection entre les bandes afin de séparer les noyaux d'alliages magnétiques entre les bandes.

Selon un mode particulier de réalisation, le procédé consiste à coller au moins une couche d'alliages nanocristallins ou d'un autre type d'alliage magnétique sur la plaque support.

Selon un autre mode particulier de réalisation, le procédé consiste en un dépôt sous vide de l'alliage sur tout ou partie de la plaque support.

Selon un autre particulier de réalisation, le procédé consiste en une sérigraphie des alliages magnétiques en poudre enrobés dans un polymère.

Selon une variante de réalisation, le procédé consiste à assembler chaque bande avec un bobinage tubulaire enfilé sur la bande.

Selon une autre variante de réalisation, le procédé consiste à assembler chaque bande avec un bobinage plat.

Avantageusement, le procédé consiste à monter un bobinage plat sur chaque bande de la plaque support, collé avec interposition d'un isolant, sur le noyau d'alliages nanocristallins.

Selon une autre variante de réalisation, le procédé consiste à déposer le noyau d'alliages magnétiques sur chaque bande avec une largeur et une forme évolutive selon la direction d'extension de la bande.

Selon une variante préférée de réalisation, le procédé consiste :
- à prédécouper trois bandes dont deux s'étendent selon des axes perpendiculaires tandis que l'axe de la troisième bande forme un angle de l'ordre de 135° avec l'axe de la bande voisine,
- et à plier la troisième bande de manière que l'axe d'extension forme un angle déterminé avec le plan formé par les axes des deux autres bandes.

Un autre objet de l'invention est de proposer un capteur de champ magnétique qui comporte une série de n sondes avec n ≥ = 3 composées chacune d'un noyau d'alliages magnétiques associé à un bobinage, les n sondes comportant n bandes d'une plaque support commune reliées ensemble par une zone dʹintersection en s'étendant selon n axes concourants en un point d'intersection et qui forment une pièce unique, avec au moins une bande pliée selon une ligne de pliage perpendiculaire à son axe.

Selon une variante de réalisation, le capteur comporte en tant qu'un noyau d'alliages magnétiques, au moins une couche d'alliages nanocristallins collée sur une bande, ou une couche d'alliages magnétiques déposée par les techniques de dépôt couche mince sous vide, ou une couche de composite magnétique déposée par les techniques de sérigraphie.

Selon une variante de réalisation, un bobinage tubulaire est enfilé autour de chaque bande de la plaque support.

Selon une variante de réalisation, un bobinage plat est fixé sur chaque bande de la plaque support.

Avantageusement, chaque noyau d'alliages magnétiques présente une largeur et une forme évolutives selon l'axe d'extension de la bande de la plaque support associée.

Selon lʹinvention, chaque noyau d'alliages magnétiques présente par rapport à son milieu, une largeur diminuant ou augmentant progressivement de manière symétrique par rapport à l'axe d'extension de la bande.

Selon l'invention, chaque noyau d'alliages magnétiques présente au moins une zone d'étranglement centrée par rapport à l'axe d'extension de la bande constituant une zone de saturation pour la sonde associée.

Diverses autres caractéristiques ressortent de la description faite ci-dessous en référence aux dessins annexés qui montrent, à titre d'exemples non limitatifs, des formes de réalisation de l'objet de l'invention.

La **Figure 1** est une vue d'un exemple de réalisation d'un capteur de champ magnétique conforme à lʹinvention.

Les **Figures 2** à **6** sont des vues en plan du capteur de champ magnétique conforme à lʹinvention illustré dans différentes phases caractéristiques de fabrication.

La **Figure 7** est une vue en coupe élévation montrant une autre étape caractéristique de fabrication du capteur de champ magnétique conforme à lʹinvention.

La **Figure 8** est une vue en plan d'une autre étape de fabrication du capteur de champ magnétique conforme à lʹinvention.

La **Figure 9** illustre une vue en coupe d'une autre variante de réalisation d'un capteur de champ magnétique conforme à lʹinvention.

La **Figure 9A** est une vue de dessous d'un exemple de réalisation d'un bobinage plat pour le capteur conforme à lʹinvention.

Les **Figures 10A** à **10D** illustrent différentes formes caractéristiques de réalisation d'un noyau pour un capteur de champ magnétique conforme à l'invention.

La **Figure 11** illustre un schéma de réalisation d'un capteur de champ magnétique conforme à lʹinvention comportant quatre sondes.

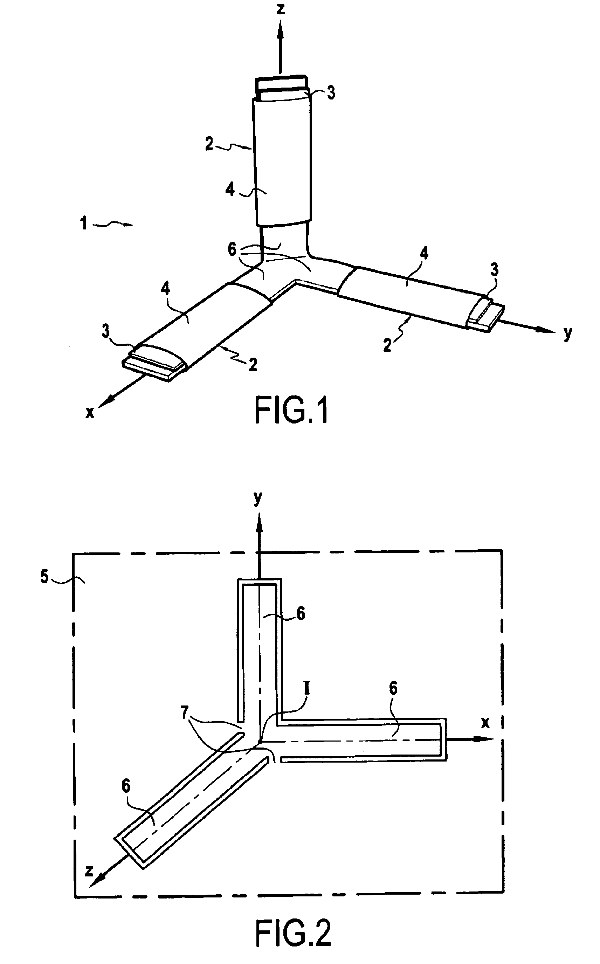

Tel que cela ressort plus précisément de la **Fig. 1****,** l'objet de lʹinvention concerne un capteur de champ magnétique **1** comportant une série de n sondes **2** avec n supérieur ou égale à 3. Chaque sonde **2** comporte un axe ou une direction de mesure respectivement **x, y, z, ....** Dans l'exemple de réalisation illustré aux **Fig. 1** à **8****,** le capteur de champ magnétique **1** comporte trois sondes **2** avec les trois axes **x, y, z** orthogonaux entre eux. Chaque sonde **2** comporte un noyau **3** d'alliages magnétiques associés à un bobinage **4.**

La fabrication d'un tel capteur **1** est réalisée selon le procédé décrit ci-après en relation des **Fig. 2** à **8****.**

Tel que cela ressort plus précisément de la **Fig. 2****,** le procédé consiste à prédécouper dans une plaque support amagnétique **5,** une série de n bandes **6** (avec n ≥ = 3 et n = 3 dans l'exemple illustré) s'étendant selon des axes concourants **x, y, z** en un point d'intersection **I,** ces bandes **6** étant reliées ensemble par une zone dʹintersection ou de jonction commune **z.** Les bandes **6** s'étendant selon les axes **x, y** sont décalées entre elles d'un angle de 90°, tandis que la bande **6** qui s'étend selon l'axe **z** est décalée d'une valeur de 135° par rapport à chaque bande **6** d'axe respectivement **x, y.** Il est à noter que les trois bandes **6** sont maintenues reliées à la plaque support **5** par au moins une et dans l'exemple illustré deux attaches **7**. Il doit être compris que la découpe des bandes **6** est réalisée tout autour des bandes à l'exception des zones de liaison formant les attaches **7.** Le ou les attaches **7** sont positionnées de manière à délimiter une ou plusieurs lignes de pliage **l** pour une ou plusieurs bandes **6.**

Dans l'exemple illustré, les deux attaches **7** sont formées dans le prolongement de la bande **6** d'axe **z,** au niveau de la jonction avec les deux autres bandes **6** d'axes **x, y.** Ces deux attaches **7** disposées de part et d'autre de la bande **6** d'axe **z** permet le pliage de cette bande **6** d'axe **z** au niveau de la jonction avec les deux autres bandes **6** d'axe **x, y,** comme cela sera expliqué dans la suite de la description. Par exemple, cette plaque support amagnétique **5** est réalisée par une plaque métallique amagnétique ou de préférence par une plaque en polymère mince. En tant que plaque métallique amagnétique, il peut être prévu de prendre selon la fréquence du signal, par exemple un inox austénitique amagnétique, ou de l'aluminium, ou du cuivre et de ses alliages amagnétiques. En tant que support polymère, il peut être choisi un polymère de type Poly Chlorure de Vinyle (PVC), Polyester, Polyoléfine (Polyéthylène, polypropylène).

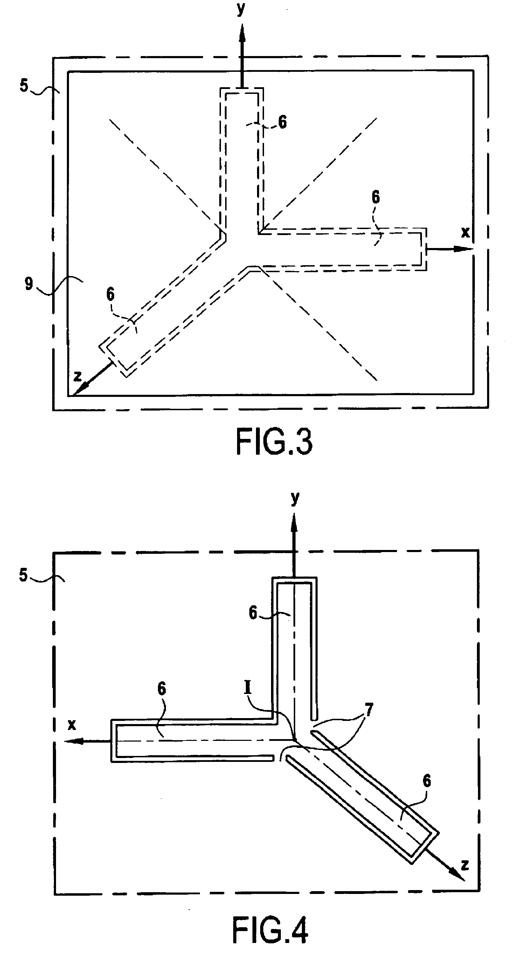

Le procédé selon l'invention consiste à déposer une ou plusieurs couches d'alliages magnétiques **9** sur tout ou partie des bandes **6** de la plaque support **5** afin de constituer le noyau **3** des sondes. Selon une caractéristique préférée de réalisation illustrée à la **Fig. 3****,** le procédé consiste à déposer une ou plusieurs couches minces d'alliages nanocristallins **9** sur l'ensemble de la plaque support **5.** Par exemple, chaque bande d'alliages nanocristallins est collée sur la plaque support comme décrit par exemple dans les documents WO 2005/002308 et WO 00/43556. A titre d'exemple, les alliages suivants peuvent être utilisés : alliages de cuivre, alliages CoCrNi, des alliages de titane, etc.. Par exemple, chaque couche mince d'alliages nanocristallins possède une épaisseur de l'ordre de 20 µm et se trouve séparée de la plaque support par de la colle assurant une fonction dʹisolation électrique.

Bien entendu, la réalisation du noyau **3** des sondes peut être obtenue à l'aide de techniques différentes. Par exemple, il peut être envisagé de déposer une ou plusieurs couches d'alliages magnétiques minces par des techniques de dépôt sous vide d'évaporation ou de pulvérisation cathodique (par exemple des alliages fer-nickel d'épaisseur de quelques µm). Une autre variante de réalisation consiste à déposer par des techniques de sérigraphie, des alliages magnétiques en poudre enrobés dans un polymère par exemple de type époxy.

Ces différentes techniques permettent de réaliser les noyaux d'alliages magnétiques **3** sur tout ou partie des bandes **6** des différentes sondes, qui forment une pièce unique restant attachée à la plaque support **5** par le ou les attaches **7.** Bien entendu, le dépôt des noyaux d'alliages magnétiques **3** peut être réalisé sur tout ou partie de la surface de la plaque support **5** correspondant uniquement aux bandes **6.** Bien entendu, ce dépôt peut s'étendre également en dehors des bandes 6, sur tout ou partie de la plaque support **5.**

Dans l'exemple de réalisation décrit en relation des **Fig. 2** à **8****,** le dépôt du noyau d'alliages magnétiques est effectué sur l'ensemble de la plaque support **5.** Selon cet exemple de réalisation, le procédé consiste à prédécouper la ou les couches d'alliages magnétiques **9** suivant le contour des bandes **6** et en laissant subsister les attaches **7.** Selon une caractéristique de réalisation, une telle découpe est réalisée par une opération de gravure laser ou par micro-sablage. A cet effet, et tel que cela ressort plus précisément de la **Fig. 4****,** la ou les couches d'alliages magnétiques **9** sont gravées en retournant la plaque de support **5** qui sert de cache.

Dans la description qui précède, le dépôt des noyaux d'alliages magnétiques **3** sur la plaque support **5** est réalisé avant l'étape de découpage des bandes **6** en les laissant reliées à la plaque support **5** par au moins une attache **7.** Bien entendu, les étapes de dépôt et de découpe peuvent être inversées. Ainsi, l'étape de découpe des bandes **6** en les laissant reliées à la plaque support **5** peut être réalisée avant l'étape de dépôt des noyaux d'alliages magnétiques **3** sur tout ou partie de la plaque support **5** et en particulier sur tout ou partie des bandes **6.**

Les noyaux **3** des bandes **6** formés par la ou les couches d'alliages magnétiques **9** sont reliés entre eux au niveau de la zone d'intersection **z** des bandes **6.** Selon un mode de réalisation, les sondes **2** possèdent un noyau commun de sorte que la ou les couches d'alliages magnétiques **9** formées sur les diverses bandes **6** sont reliées entre elles.

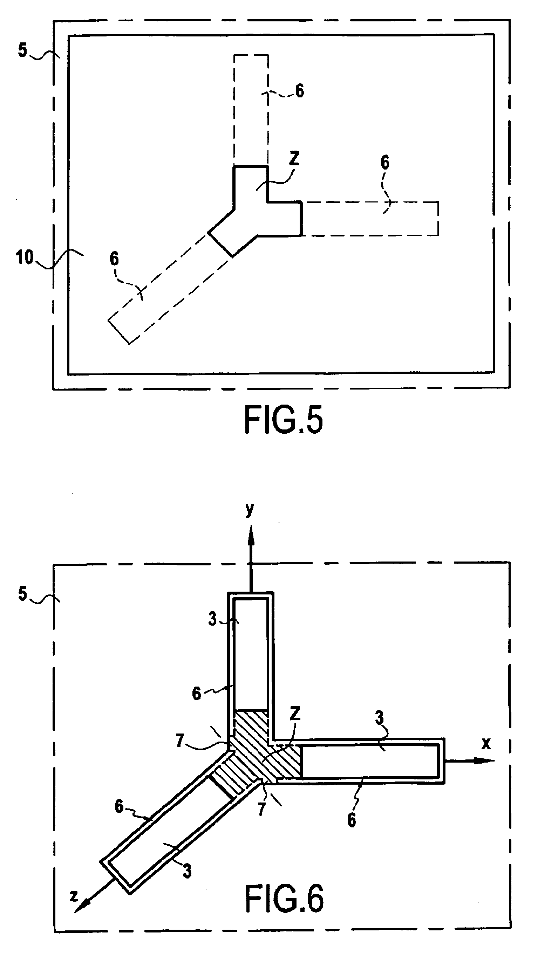

Selon un autre mode de réalisation, le procédé consiste à supprimer la ou les couches d'alliages magnétiques **9** de la zone d'intersection **Z** des bandes **6** afin de séparer entre elles les couches d'alliages magnétiques **9** des bandes **6.** Dans le mode de réalisation illustré, et tel que cela ressort de la **Fig. 5****,** un cache métallique **10** est placé pour recouvrir l'ensemble des bandes **6** à l'exception de la zone dʹintersection **Z** des bandes **6.** Ces couches d'alliages magnétiques **9** sont ainsi supprimées par exemple par micro-sablage au niveau de l'absence du cache métallique **10**. Tel que cela ressort plus précisément de la **Fig. 6****,** il est ainsi obtenu trois bandes **6** pourvues chacune d'un noyau nanocristallin **3** indépendant. Les noyaux **3** des bandes **6** sont séparés les uns des autres par la zone dʹintersection **Z** dépourvue des couches d'alliages magnétiques **9.** Bien entendu, il peut être envisagé de remplacer le cache métallique par une couche de polymère ou d'élastomère, sérigraphiée dans les zones à protéger de la gravure. De même, il peut être envisagé de supprimer les couches d'alliages magnétiques **9** par gravure chimique.

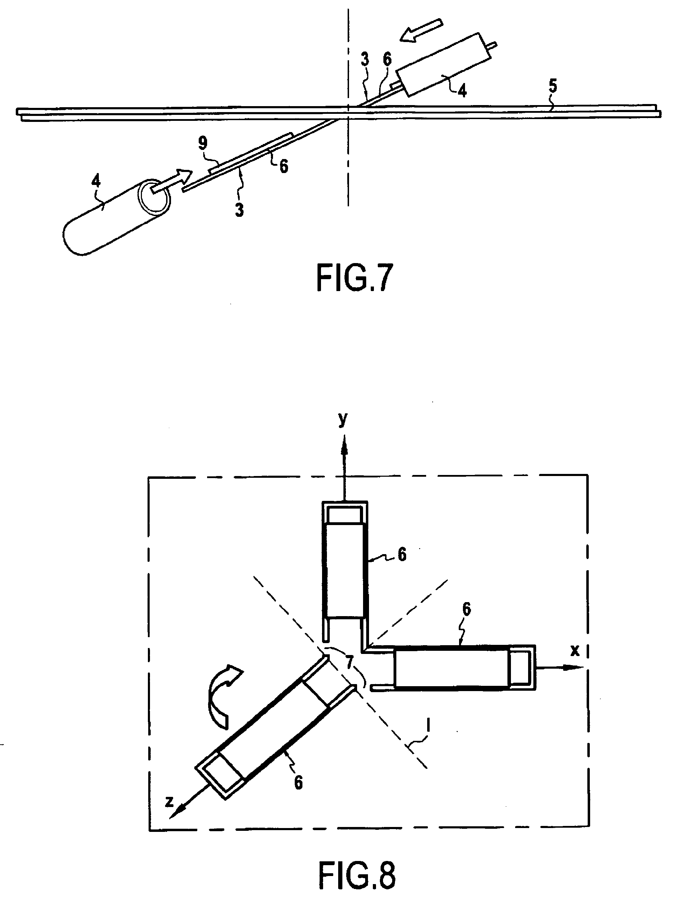

Le procédé selon l'invention consiste ensuite à assembler chaque bande **6** ou noyau **3** avec un bobinage **4.** Dans l'exemple de réalisation illustré à la **Fig. 7****,** le bobinage **4** présente une forme tubulaire. Selon cette variante de réalisation, les bandes **6** sont pliées autour des attaches **7** de manière à permettre d'enfiler chaque bobine **4** autour d'une bande **6.** Chaque bobine **4** est ainsi engagée par l'extrémité libre d'une bande **6.**

Le procédé selon lʹinvention consiste (comme illustré à la **Fig. 8****)** à assurer le pliage d'au moins une bande **6** selon une ligne de pliage 1 perpendiculaire à son axe de manière que l'axe de cette bande **6** se trouve perpendiculaire au plan formé par les bandes s'étendant dans le plan de la plaque support **5.** Dans l'exemple illustré, la bande **6** d'axe **z** est pliée selon la ligne de pliage **l** délimitée par les deux attaches **7** et s'étendant perpendiculairement à l'axe **z.** La bande **6** d'axe **z** est pliée avec un angle de 90° par rapport au plan de la plaque support **5** dans lequel s'étendent les bandes **6** d'axes **x, y.** Dans la mesure où les bandes **6** d'axe **x** et **y** sont perpendiculaires entre elles, en raison de leur découpage perpendiculaire dans la plaque support commune **5,** il est obtenu un ensemble de trois sondes perpendiculaires deux à deux.

Après l'opération de pliage, les attaches **7** peuvent être éventuellement supprimées pour détacher le capteur de la plaque support **5.** En effet, il peut être prévu que le capteur **1** puisse être utilisé en restant attaché à la plaque support **5.**

Dans l'exemple de réalisation illustré aux **Fig. 1** à **8****,** chaque bande **6** est associée avec un bobinage tubulaire **4.**

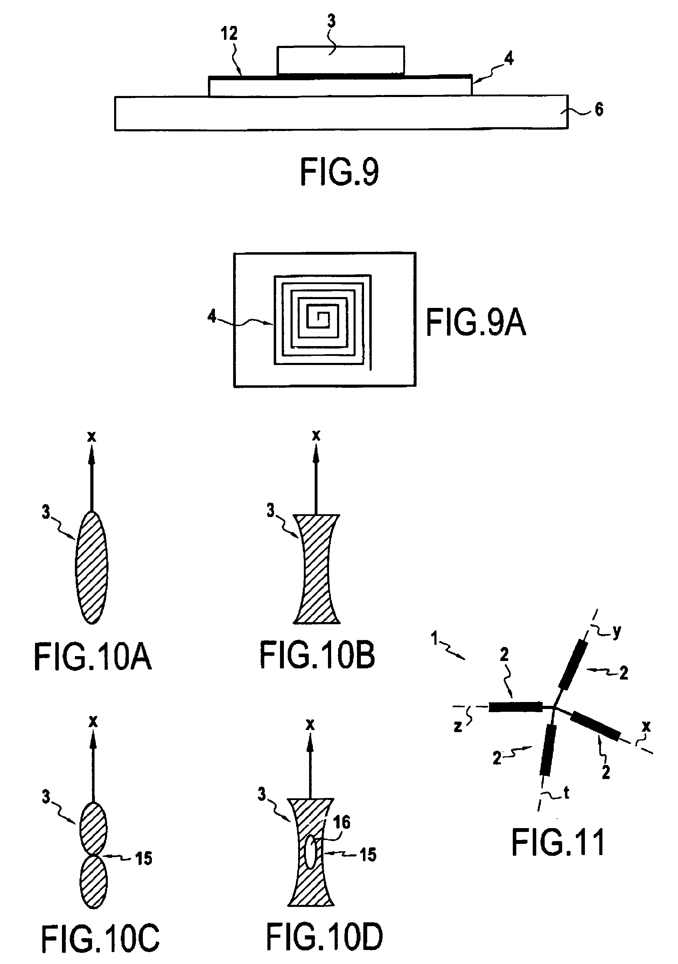

Dans l'exemple illustré à la **Fig. 9****,** chaque bande **6** peut être associée avec un bobinage plat **4.** Selon cet exemple de réalisation, un bobinage plat **4** est fixé sur chaque bande **6** de la plaque support. Par exemple, le bobinage **4** est gravé directement sur la plaque support **5.** Le bobinage plat **4** peut présenter une forme circulaire ou rectangulaire comme illustré à la **Fig. 9A****.** Le noyau d'alliages magnétiques **3** est fixé sur le bobinage plat **4** avec interposition d'un isolant **12.** Le bobinage plat **4** et le noyau **3** sont positionnés ainsi en regard ou l'un en face de l'autre. Comme expliqué ci-dessus, le noyau **3** peut être réalisé par une ou plusieurs couches d'alliages nanocristallins collées sur la plaque support où sont réalisés les bobinages plats **4.** Bien entendu, les bandes **6** sont formées et découpées selon les techniques décrites ci-dessus.

Selon l'exemple de réalisation illustré sur les **Fig. 1** à **10****,** chaque noyau d'alliages magnétiques **3** présente une largeur constante le long de son axe **x, y,** ou **z.**

Dans les exemples illustrés aux **Fig. 10** à **10D****,** chaque noyau d'alliages magnétiques **3** présente une largeur ou une forme évolutive selon l'axe d'extension de la bande **6.**

Dans lʹexemple illustré aux **Fig. 10** et **10B****,** chaque noyau d'alliages magnétiques **3** présente par rapport à son milieu, respectivement une largeur diminuant ou augmentant progressivement de manière symétrique par rapport à l'axe d'extension par exemple **x** de la bande. Les formes illustrées aux **Fig. 10A** et **10B** permettent respectivement d'augmenter et de diminuer l'anisotropie du capteur.

Selon un autre exemple de réalisation illustré aux **Fig. 10C** et **10D****,** chaque noyau **3** présente au moins une zone d'étranglement **15** centrée par rapport à l'axe d'extension **x** de la bande. Cette zone d'étranglement **15** constitue une zone de saturation pour la sonde associée. Les variantes illustrées aux **Fig. 10C** et **10D** permettent d'augmenter la sensibilité des sondes mettant en oeuvre respectivement les noyaux illustrés aux **Fig. 10A** et **10B****.** Il apparaît en effet une saturation du noyau au niveau de l'étranglement **15.** Dans les exemples illustrés aux **Fig. 10C** et **10D****,** l'étranglement **15** est réalisé respectivement par une diminution de la largeur du noyau et par la réalisation d'un trou **16** au centre du noyau **3.**

Il ressort de la description qui précède que l'objet de l'invention permet de réaliser un capteur avec une série de sondes convenablement orientées les unes par rapport aux autres en vue de déterminer l'orientation et l'intensité d'un champ magnétique. Le procédé selon lʹinvention permet de positionner précisément et facilement les sondes **2** les unes par rapport aux autres puisque les sondes **2** sont réalisées à partir d'une unique plaque support **5** dans laquelle des bandes **6** sont prédécoupées en laissant subsister des attaches **7** délimitant au moins une ligne de pliage pour une bande par rapport aux autres bandes. Bien entendu, le capteur peut comporter un nombre différent de sondes et présenter des angulations diverses entre elles en fonction des applications envisagées.

Ainsi, dans l'exemple décrit en relation des **Fig. 1** à **8****,** le capteur **1** comporte trois sondes **2** avec trois axes orthogonaux entre eux. Il est clair quʹil peut être prévu que les axes de mesure des sondes présentent entre eux des angulations différentes de 90° en étant réparties selon les trois dimensions. Dans le même sens, il peut être envisagé de réaliser un capteur avec un nombre de sonde supérieur à 3. Une telle solution permet en particulier d'augmenter la sensibilité du capteur selon un axe privilégié de mesure en améliorant la précision du calcul du vecteur champ magnétique.

La **Fig. 11** illustre un exemple de réalisation d'un capteur de champ magnétique **1** comportant quatre sondes **2.** La direction des axes **x, y, z, t** des sondes **2** est choisie en fonction de l'application du capteur **1.** Par exemple, pour la recherche de défauts électriques dans un système électronique de puissance, il est intéressant de pouvoir connaître le champ magnétique dans des directions définies. Dans l'exemple illustré à la **Fig. 11****,** deux sondes **2** par exemple d'axes **x, t** s'établissent dans un même plan par exemple formé par le plan de la plaque support **5** tandis que les autres sondes d'axe **y, z** s'étendent en dehors de ce plan selon des angulations quelconques.

L'invention n'est pas limitée aux exemples décrits et représentés car diverses modifications peuvent y être apportées sans sortir de son cadre, défini par les revendications annexées.

## Revendications

1. Procédé de fabrication d'un capteur de champ magnétique **(1)** comportant une série de n sondes **(2),** avec n > = 3, composées chacune d'un noyau d'alliages magnétiques **(3)** associé à un bobinage **(4), caractérisé en ce qu'**il comporte les étapes suivantes :
- assurer le dépôt des noyaux d'alliages magnétiques **(3)** sur une plaque support amagnétique (**5**), sur au moins tout ou partie d'une surface correspondant à une série de n bandes **(6)** s'étendant selon des axes concourants (**x, y, z)** en un point d'intersection et reliées ensemble par une zone dʹintersection (**z**),
- avant ou après ce dépôt, découper dans ladite plaque support **(5),** les n bandes **(6)** en les laissant reliées à là plaque support **(5)** par au moins une attache **(7),**
- assembler chaque bande (**6**) avec un bobinage **(4),**
- plier au moins une bande (**6**) selon une ligne de pliage perpendiculaire à son axe.

2. Procédé selon la revendication 1, **caractérisé en ce qu**ʹil consiste à supprimer le ou les attaches **(7)** pour détacher le capteur de la plaque support **(5).**

3. Procédé selon la revendication 1 ou 2, **caractérisé en ce qu'**il consiste :
- à prédécouper le noyau d'alliages magnétiques **(3)** en suivant le contour des bandes **(6)** et en laissant subsister au moins une attache **(7),**
- à supprimer éventuellement le noyau d'alliages magnétiques **(3)** de la zone d'intersection entre les bandes afin de séparer les noyaux d'alliages magnétiques entre les bandes.

4. Procédé selon l'un des revendications 1 à 3, **caractérisé en ce que** l'étape de dépôt des noyaux d'alliages magnétiques **(3)** consiste à coller au moins une couche d'alliages nanocristallins ou d'un autre type d'alliage magnétique sur la plaque support **(5).**

5. Procédé selon l'une des revendications 1 à 3, **caractérisé en ce que**
l'étape de dépôt des noyaux dʹalliages magnétiques **(3)** consiste en un dépôt sous vide de l'alliage sur tout ou partie de la plaque support **(5).**

6. Procédé selon l'une des revendications 1 à 3, **caractérisé en ce que** l'étape de dépôt des noyaux d'alliages magnétiques **(3)** consiste en une sérigraphie des alliages magnétiques en poudre enrobés dans un polymère.

7. Procédé selon la revendication 1, **caractérisé en ce qu'**il consiste à assembler chaque bande (**6**) avec un bobinage tubulaire **(4)** enfilé sur la bande.

8. Procédé selon la revendication 1, **caractérisé en ce qu'**il consiste à assembler chaque bande **(6)** avec un bobinage plat **(4).**

9. Procédé selon la revendication 8, **caractérisé en ce qu'**il consiste à monter un bobinage plat **(4)** sur chaque bande **(6)** de la plaque support (**5**), collé avec interposition d'un isolant **(12),** sur le noyau d'alliages nanocristallins **(3).**

10. Procédé selon l'une des revendications 1 à 9, **caractérisé en ce qu'**il consiste à déposer le noyau d'alliages magnétiques **(3)** sur chaque bande **(6)** avec une largeur et une forme évolutive selon la direction d'extension de la bande.

11. Procédé selon la revendication 1, **caractérisé en ce qu'**il consiste:
- à prédécouper trois bandes **(6)** dont deux s'étendent selon des axes perpendiculaires **(x, y**) tandis que l'axe **(z)** de la troisième bande forme un angle de l'ordre de 135° avec l'axe de la bande voisine,
- et à plier la troisième bande de manière que l'axe d'extension forme un angle déterminé avec le plan formé par les axes des deux autres bandes.

12. Capteur de champ magnétique comportant une série de n sondes **(2),** avec n > = 3, composées chacune d'un noyau d'alliages magnétiques **(3)** associé à un bobinage **(4),** et s'étendant selon **n** axes concourants (**x**; **y**, **z**, **t** ...) en un point d'intersection (**I**), **caractérisé en ce que** les n sondes comportent n bandes **(6)** d'une plaque support commune **(5)** reliées ensemble par une zone dʹintersection (**Z**) et qui forment une pièce unique, avec au moins une bande **(6)** pliée selon une ligne de pliage perpendiculaire à son axe.

13. - Capteur de champ magnétique selon la revendication 11, **caractérisé en ce qu'**il comporte en tant qu'un noyau d'alliages magnétiques **(3),** au moins une couche d'alliages nanocristallins collée sur une bande **(6).**

14. Capteur de champ magnétique selon la revendication 11, **caractérisé en ce qu'**un bobinage tubulaire **(4)** est enfilé autour de chaque bande **(6)** de la plaque support **(5).**

15. Capteur de champ magnétique selon la revendication 11, **caractérisé en ce qu'**un bobinage plat **(4)** est fixé sur chaque bande **(6)** de la plaque support **(5).**

16. Capteur de champ magnétique selon la revendication 11 ou 12, **caractérisé en ce que** chaque noyau d'alliages magnétiques **(3)** présente une largeur et une forme évolutive selon l'axe d'extension de la bande **(6)** de la plaque support associée.

17. Capteur de champ magnétique selon la revendication 16, **caractérisé en ce que** chaque noyau d'alliages magnétiques **(3)** présente par rapport à son milieu, une largeur diminuant ou augmentant progressivement par rapport à l'axe d'extension de la bande.

18. Capteur de champ magnétique selon la revendication 16, **caractérisé en ce que** chaque noyau d'alliages magnétiques **(3)** présente au moins une zone d'étranglement (**15**) centrée par rapport à l'axe d'extension de la bande constituant une zone de saturation pour la sonde associée.

## Claims

1. Method to manufacture a magnetic field sensor **(1)** comprising a series of n probes **(2),** in which n > = 3, each consisting of a core of magnetic alloys **(3)** associated with a coil **(4), characterized in that** it comprises the following steps:
- ensuring the deposit of cores of magnetic alloys **(3)** on a nonmagnetic substrate **(5),** on at least all or part of a surface corresponding to a series of n strips **(6)** extending along axes **(x, y, z)** concurrent at a point of intersection and joined together by an intersection region **(z),**
- before or after this deposit, cutting the n strips **(6)** in said substrate **(5),** leaving them joined to the substrate **(5)** by at least one attachment **(7),**
- assembling each strip **(6)** with a coil **(4),**
- folding at least one strip **(6)** along a fold line perpendicular to its axis.

2. Method according to claim 1, **characterized in that** it consists of removing the attachment(s) **(7)** to detach the sensor from the substrate **(5).**

3. Method according to claim 1 or 2, **characterized in that** it consists of:
- cutting out the core of magnetic alloys **(3)** following the contour of the strips **(6)** leaving at least one subsisting attachment **(7),**
- optionally removing the core of magnetic alloys **(3)** at the intersection region between the strips to separate the cores of magnetic alloys between the strips.

4. Method according to any of claims 1 to 3, **characterized in that** the step to deposit cores of magnetic alloys **(3)** consists of bonding at least one layer of nanocrystalline alloys or another type of magnetic alloy onto the substrate **(5).**

5. Method according to any of claims 1 to 3, **characterized in that** the step to deposit cores of magnetic alloys **(3)** consists of vacuum depositing the alloy on all or part of the substrate **(5).**

6. Method according to any of claims 1 to 3, **characterized in that** the step to deposit cores of magnetic alloys **(3)** consists of serigraphy of powder magnetic alloys coated with a polymer.

7. Method according to claim 1, **characterized in that** it consists of assembling each strip **(6)** with a tubular coil **(4)** placed around the strip.

8. Method according to claim 1, **characterized in that** it consists of assembling each strip **(6)** with a flat coil **(4).**

9. Method according to claim 8, **characterized in that** it consists of mounting a flat coil **(4)** on each strip **(6)** of the substrate **(5),** bonded with inter-positioning of an insulator **(12),** onto the core of nanocrystalline alloys **(3).**

10. Method according to any of claims 1 to 9, **characterized in that** it consists of depositing the core of magnetic alloys **(3)** on each strip **(6)** with changing width and shape in the direction of the extension of the strip.

11. Method according to claim 1, **characterized in that** it consists of:
- cutting out three strips **(6)** of which two extend along perpendicular axes **(x, y**) whilst axis **(z)** of the third strip forms an angle of the order of 135° with the axis of the neighbouring strip,
- and of folding the third strip so that the axis of extension forms a determined angle with the plane formed by the axes of the two other strips.

12. Magnetic field sensor comprising a series of n probes **(2),** in which n > = 3, each consisting of a core of magnetic alloys **(3)** associated with a coil **(4),** and by extending along axes **(x; y, z, t ...**) concurrent at a point of intersection **(I) characterized in that** the n probes comprise n strips **(6)** of a common substrate **(5)** joined together via an intersection region **(z)** and which form a simple piece, with at least a strip **(6)** folded along a fold line of perpendicular to its axis.

13. Magnetic field sensor according to claim 11, **characterized in that**, as core of magnetic alloys **(3),** it comprises at least one layer of nanocrystalline alloys bonded onto a strip **(6).**

14. Magnetic field sensor according to claim 11, **characterized in that** a tubular coil **(4)** is placed around each strip **(6)** of the substrate **(5).**

15. Magnetic field sensor according to claim 11, **characterized in that** a flat coil **(4)** is fixed to each strip **(6)** of the substrate **(5).**

16. Magnetic field sensor according to claim 11 or 12, **characterized in that** each core of magnetic alloys **(3)** has a changing width and shape along the axis of extension of the strip **(6)** of the associated substrate.

17. Magnetic field sensor according to claim 16, **characterized in that** each core of magnetic alloys **(3),** relative to its medium, has a width which decreases or increases progressively relative to the axis of extension of the strip.

18. Magnetic field sensor according to claim 16, **characterized in that** each core of magnetic alloys **(3)** has at least one bottleneck region (**15**), that is centred relative to the axis of extension of the strip, forming a saturation region for the associated probe.

## Patentansprüche

1. Verfahren zur Herstellung eines Magnetfeldsensors (1), der eine Reihe von n Sonden (2), mit n > = 3, umfaßt, die jeweils aus einem Kern aus Magnetlegierungen (3) bestehen, der einer Spule (4) zugeordnet ist, **dadurch gekennzeichnet, daß** es die folgenden Schritte umfaßt:
- Sicherstellen des Aufbringens der Magnetlegierungskerne (3) auf eine nichtmagnetische Tragplatte (5), über wenigstens die Gesamtheit oder einen Teil einer Fläche, die einer Reihe von n Streifen (6) entspricht, welche sich entlang von in einem Schnittpunkt zusammenlaufenden Achsen (x, y, z) erstrecken und durch einen Schnittbereich (Z) miteinander verbunden sind,
- vor oder nach diesem Aufbringen, Ausschneiden der n Streifen (6) aus der Tragplatte (5), wobei man sie durch wenigstens ein Verbindungsstück (7) mit der Tragplatte (5) verbunden läßt,
- Verbinden eines jeden Streifens (6) mit einer Spule (4),
- Falten wenigstens eines Streifens (6) entlang einer zu seiner Achse senkrecht verlaufenden Faltlinie.

2. Verfahren nach Anspruch 1, **dadurch gekennzeichnet, daß** es darin besteht, das oder die Verbindungsstück(e) (7) zu entfernen, um den Sensor von der Tragplatte (5) zu lösen.

3. Verfahren nach Anspruch 1 oder 2, **dadurch gekennzeichnet, daß** es darin besteht:
- den Magnetlegierungskern (3) unter Folgen der Kontur der Streifen (6) und unter Bestehenlassen wenigstens eines Verbindungsstückes (7) vorzuschneiden,
- eventuell den Magnetlegierungskern (3) aus dem Schnittbereich zwischen den Streifen zu entfernen, um die Magnetlegierungskerne zwischen den Streifen zu trennen.

4. Verfahren nach einem der Ansprüche 1 bis 3, **dadurch gekennzeichnet, daß** der Schritt des Aufbringens der Magnetlegierungskerne (3) darin besteht, wenigstens eine Schicht aus nanokristallinen Legierungen oder aus einer anderen Art von Magnetlegierung auf die Tragplatte (5) zu kleben.

5. Verfahren nach einem der Ansprüche 1 bis 3, **dadurch gekennzeichnet, daß** der Schritt des Aufbringens der Magnetlegierungskerne (3) in einem Abscheiden unter Vakuum der Legierung auf der Gesamtheit oder einem Teil der Tragplatte (5) besteht.

6. Verfahren nach einem der Ansprüche 1 bis 3, **dadurch gekennzeichnet, daß** der Schritt des Aufbringens der Magnetlegierungskerne (3) in einem Siebdrucken der in ein Polymer eingebetteten, pulverförmigen Magnetlegierungen besteht.

7. Verfahren nach Anspruch 1, **dadurch gekennzeichnet, daß** es darin besteht, einen jeden Streifen (6) mit einer über den Streifen gestreiften röhrenförmigen Spule (4) zu verbinden.

8. Verfahren nach Anspruch 1, **dadurch gekennzeichnet, daß** es darin besteht, einen jeden Streifen (6) mit einer Flachspule (4) zu verbinden.

9. Verfahren nach Anspruch 8, **dadurch gekennzeichnet, daß** es darin besteht, auf jedem Streifen (6) der Tragplatte (5) eine Flachspule (4) anzubringen, die unter Einfügen eines Isolators (12) auf den Kern aus nanokristallinen Legierungen (3) geklebt ist.

10. Verfahren nach einem der Ansprüche 1 bis 9, **dadurch gekennzeichnet, daß** es darin besteht, den Magnetlegierungskern (3) auf jeden Streifen (6) mit einer Breite und einer Form, die entlang der Erstreckungsrichtung des Streifens veränderlich ist, aufzubringen.

11. Verfahren nach Anspruch 1, **dadurch gekennzeichnet, daß** es darin besteht:
- drei Streifen (6) vorzuschneiden, von denen zwei entlang von senkrechten Achsen (x, y) verlaufen, während die Achse (z) des dritten Streifens einen Winkel in der Größenordnung von 135° mit der Achse des benachbarten Streifens bildet, und
- den dritten Streifen derart zu falten, daß die Erstreckungsachse einen bestimmten Winkel mit der durch die Achsen der beiden anderen Streifen gebildeten Ebene bildet.

12. Magnetfeldsensor, der eine Reihe von n Sonden (2), mit n > = 3, umfaßt, die jeweils aus einem Kern aus Magnetlegierungen (3), der einer Spule (4) zugeordnet ist, bestehen und die sich entlang von in einem Schnittpunkt (I) zusammenlaufenden n Achsen (x; y, z, t ...) erstrecken, **dadurch gekennzeichnet, daß** die n Sonden n Streifen (6) einer gemeinsamen Tragplatte (5) umfassen, die durch einen Schnittbereich (Z) miteinander verbunden sind und die ein einziges Teil, mit wenigstens einem Streifen (6), der entlang einer zu seiner Achse senkrecht verlaufenden Faltlinie gefaltet ist, bilden.

13. Magnetfeldsensor nach Anspruch 11, **dadurch gekennzeichnet, daß** er als einen Magnetlegierungskern (3) wenigstens eine Schicht aus nanokristallinen Legierungen, die auf einen Streifen (6) aufgeklebt ist, umfaßt.

14. Magnetfeldsensor nach Anspruch 11, **dadurch gekennzeichnet, daß** eine röhrenförmige Spule (4) um jeden Streifen (6) der Tragplatte (5) aufgeschoben ist.

15. Magnetfeldsensor nach Anspruch 11, **dadurch gekennzeichnet, daß** eine Flachspule (4) an jedem Streifen (6) der Tragplatte (5) befestigt ist.

16. Magnetfeldsensor nach Anspruch 11 oder 12, **dadurch gekennzeichnet, daß** jeder Magnetlegierungskern (3) eine Breite und eine Form aufweist, die entlang der Erstreckungsachse des Streifens (6) der zugeordneten Tragplatte veränderlich ist.

17. Magnetfeldsensor nach Anspruch 16, **dadurch gekennzeichnet, daß** jeder Magnetlegierungskern (3) bezogen auf seine Mitte eine Breite aufweist, die gegenüber der Erstreckungsachse des Streifens schrittweise abnimmt oder zunimmt.

18. Magnetfeldsensor nach Anspruch 16, **dadurch gekennzeichnet, daß** jeder Magnetlegierungskern (3) wenigstens einen gegenüber der Erstreckungsachse des Streifens zentrierten Einschnürungsbereich (15), der einen Sättigungsbereich für die zugeordnete Sonde bildet, aufweist.
